# EUROPEAN PATENT SPECIFICATION

(11) **EP 0 660 410 B1**
(45) Date of publication and mention of the grant of the patent: **02.05.2002**
(21) Application number: 94308276.8
(22) Date of filing: 10.11.1994
(51) Int. Cl.: H01L 23/58

(54) **Improvements in or relating to multi-slot input/outputs**
Verbesserungen in oder in Bezug auf multi-slot input/outputs
Améliorations concernant multi-slot input/outputs

(30) Priority: 10.11.1993 GB 9323144
(43) Date of publication of application: 28.06.1995
(73) Proprietor: TEXAS INSTRUMENTS INCORPORATED, Dallas Texas 75265 (US); TEXAS INSTRUMENTS LIMITED, Bedford MK41 7PA (GB)
(72) Inventor: Pathak, Vijay, c/o Texas Instruments Ltd., Bedford MK41 7PA (GB)
(74) Representative: Blanco White, Henry Nicholas

(56) References cited:
- EP-A- 0 349 294
- US-A- 4 809 029
- US-A- 4 992 845
- PATENT ABSTRACTS OF JAPAN, unexamined applications, E field, vol. 12, no. 24, January 23, 1988, THE PATENT OFFICE JAPANESE GOVERNMENT page 43 E 576; & JP-A-62 179 744 (NEC)
- 'TGB 1000 TGB 2000 BiCMOS Arrays Design Manual', 1993, TEXAS INSTUMENTS

## Description

The proposed invention relates to Input/Output (I/O) structures enabling significant savings in silicon chip area. The proposed structures are particularly suitable for high speed differential input/output interfaces such as those used in ATM/SDH switching elements.

United States Patent No. 4 992 845 discloses a programmable gate array in which each input/output pad has an associated buffer for input from and/or output to the pad. In an example said in the document to be known four area respectively for p-MOS output transistors, n-MOS output transistors, p-MOS input transistors, n-MOS input transistors, are arranged in two rows. In the invention disclosed by the patent the width of the buffer is reduced by arranging all four of those areas in a single row perpendicular to the line along which the pads are arranged. Within those areas several transistors are formed and are connected in parallel to provide sufficient current. Reducing the width of the output buffer is stated to increase the number of pads which may be provided.

Japanese Patent Application No. 62-179744 discloses an integrated circuit of the standard cell type with input/output cells and associated pads arranged along its edge in rows, there being an input/output cell in each comer at each intersection point of the rows meeting at that corner.

European Patent Application No. 0 349 294 discloses a master slice integrated circuit having input output cells and associated pads arranged along its edges in rows. Each cell is divided into two regions which are arranged on a respective one of two rows parallel to the row of pads. The inner of the two rows of cell regions is arranged on a smaller pitch than that of the other row.

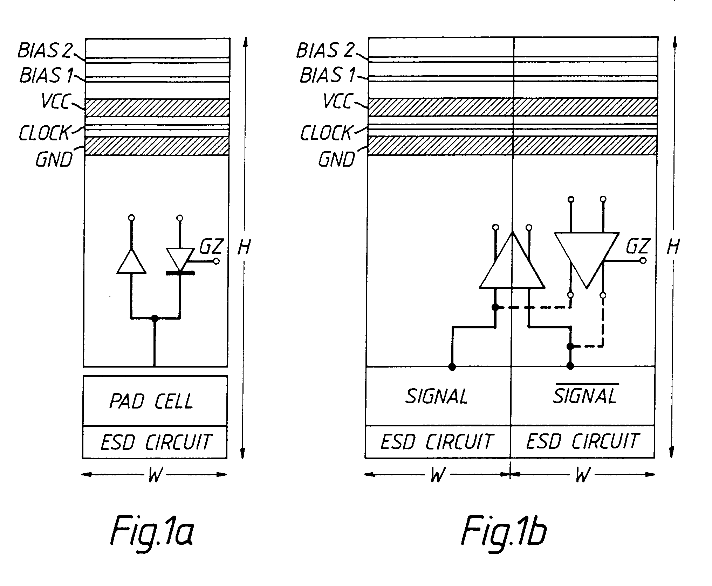

Conventional I/O structures in differential and single ended configuration are shown in Figure 1(a) and 1(b) respectively. These consist of an I/O buffer cell which contains the input or output or input/output (in the bi-directional case) circuits to provide the desired functionality. In addition, power/ground buses are routed over the I/O buffer cells to feed power to the I/Os and to the core. Sometimes global signals such as a clock and a bias reference voltage are also routed over the I/O cells.

The pad cell is made up of a bonding pad and can also include an ESD protection circuit.

The height (H) and the width (W) of the I/O typically depend upon one or more factors. One such factor is the number of interface pins required for the chip. The larger the pin count is, the narrower the I/O has to be to maximise the pin count.

Another significant factor is the minimum width of the I/O. This is determined by bonding and assembly limitations.

The width of the power buses is also a factor which affects the overall height and width of the I/O. The width of the power buses is governed by the core and I/O current requirements and the metal electromigration capability of the process technology.

In addition, both the circuit requirements for I/O functionality and ESD functionality and the global signal routing also contribute to the overall width and/or the height of the I/O.

In general, the number of interface pins and the minimum width of the I/O have greater influence on the I/O width, whilst the other factors have greater influence on the height.

In addition to the I/O cells, the VCC and GND pads shown in Figures 2 and 3 respectively which are needed to feed the current in and out of the chip normally use one I/O slot (i.e. one width of the I/O). Thus in a high performance design where a large number of VCC and GND pins are required to reduce the switching noise and power supply voltage drops, a large proportion of chip area is sacrificed for geometrical compatibility of VCC/GND pads with the input/output pads. An example of part of a conventional layout involving a large number of differential I/Os and power/ground pads is shown in Figure 4. The shaded area represents the silicon area sacrificed for geometrical compatibility described above.

One object of the present invention is to provide an I/O structure which overcomes at least some of the disadvantages of the present structures.

According to the present invention there is provided an integrated circuit having an I/O structure arranged along an edge of the integrated circuit, the I/O structure comprising
a plurality of power supply and signal contact pads arranged in a row a long said edge, and
a plurality of I/O buffer circuits arranged in an adjacent row parallel to that of the contact pads,
each of the said I/O buffer circuits being connected to a respective signal pad or differential pair of signal pads,
wherein each of the said I/O buffer circuits is longer in the direction of the said rows than it is in the direction perpendicular to that and wherein each of the said I/O buffer circuits extends in the direction of said rows so that it has a portion coextensive in that direction with the whole of its respective signal pad or differential pair of signal pads and a portion coextensive in that direction with at least a portion of a power supply pad.

Preferably each of the said I/O buffer circuits is connected to a respective differential pair of signal pads and each of the said I/O buffer circuits extends in the direction of said rows so that it has a portion coextensive in that direction with the whole of its respective differential pair of signal pads. The signal pads may be respectively input/output and complementary input/output.

The power supply pads may comprise a ground pad and a supply voltage pad.

The integrated circuit may further including a global signal routing channel.

One of the advantages of this is that there is a saving in the amount of silicon used for the I/O structure.

In addition, the I/O structure of the present invention has improved performance for high speed and high differential inputs and outputs.

Reference will now be made, by way of example to the accompanying drawings, in which:
Figure 1a is a schematic representation of a known single ended I/O;
Figure 1b is a schematic representation of a known differential I/O;

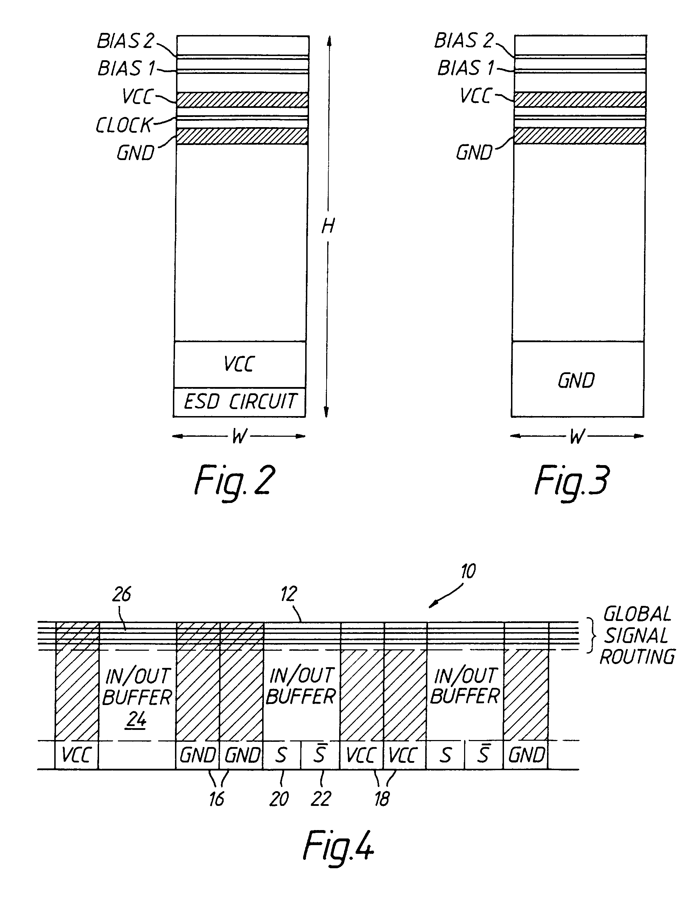

Figure 2 is a schematic representation of a known Vcc cell;
Figure 3 is a schematic representation of a known Ground cell;
Figure 4 is a conventional layout involving a large number of differential I/Os, Vcc and Ground cells;

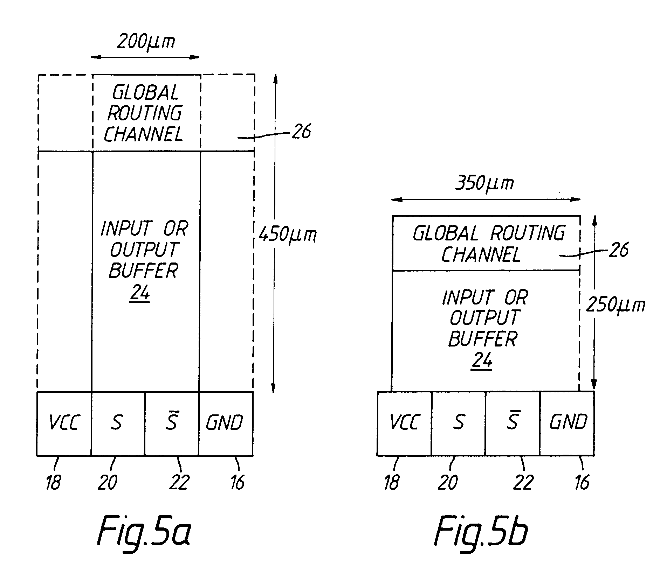

Figure 5a is a footprint of a conventional differential I/O; and
Figure 5b is a multislot I/O according to one aspect of the present invention.

Referring to Figure 4 part of a known I/O structure 10 is shown. The structure 10 comprises a core 12 and a plurality of pads 14 around the edge of the layout. The pads include ground pads 16, Vcc pads 18 and signal pads 20, 22. Associated with each pair of signal pads is an input/output buffer 24. The buffer is associated only with the signal pads and is juxtaposed thereto along the width of the pads. A global signal routing channel (26) is also included to carry Vcc busses, Ground buses, bias lines (if required), etc. Since the buffer is not required for the Vcc and GND pads there is a large area of silicon 28 (shown shaded in Figure 4) which is wasted. This area 28 is sacrificed for geometrical compatibility.

The proposed invention makes use of this shaded area by altering the aspect ratio (ratio of width to height) of the I/O buffers whilst maintaining the power feed capabilities of the structure. Increasing the differential I/O buffer width from two slot equivalent to approximately 4 slots, will halve the I/O buffer height which in turn reduces the I/O height. For example, as shown in Figure 5, by increasing the differential I/O width from 200µm to approximately 350µm, the I/O height can be reduced from 450µm to 250µm. As can be seen in Figure 5b, the overall height of the I/O structure is reduced but the area of the buffer is maintained. The buffer 24 extends along the width of the Vcc (18), Ground (16) and signal pads (20, 22). By providing the buffer in this way, the silicon area wasted by provision of the Vcc and ground pads is minimised. In addition, since a pair of power/ground pins feeds only one or a few differential pairs, the VCC/GND buses need not be as wide as used in the conventional designs which in turn helps reduce the I/O height.

The proposed I/O layout scheme is particularly useful for high speed designs requiring high differential inputs and outputs. The concept can also be extended to other applications where high speed interface is limited to a few sides of the chip. Even for single ended I/Os operating at speeds in excess of 100 MHz, a large number of power/ground pins are required to minimise the simultaneous switching noise. The proposed invention can be utilised to widen the I/O buffer layout.

Using this approach, silicon saving up to 15% has been made in Siemens KNE design. The design is implemented as a test chip (X1444) in 0.6um EPIC-3B BiCMOS technology.

The I/O structure can be used on any device which requires an I/O structure.

## Claims

1. An integrated circuit having an I/O structure arranged along an edge of the integrated circuit, the I/O structure comprising
a plurality of power supply (16,18) and signal contact (20,22) pads arranged in a row along said edge, and
a plurality of I/O buffer circuits (24) arranged in an adjacent row parallel to that of the contact pads,
each of the said I/O buffer circuits being connected to a respective signal pad or differential pair of signal pads,
wherein each of the said I/O buffer circuits is longer in the direction of the said rows than it is in the direction perpendicular to that and wherein each of the said I/O buffer circuits extends in the direction of said rows so that it has a portion coextensive in that direction with the whole of its respective signal pad or differential pair of signal pads and a portion coextensive in that direction with at least a portion of a power supply pad.

2. An integrated circuit as claimed in claim 1 wherein each of the said I/O buffer circuits (24) is connected to a respective differential pair of signal pads (20,22) and each of the said I/O buffer circuits extends in the direction of said rows so that it has a portion coextensive in that direction with the whole of its respective differential pair of signal pads.

3. An integrated circuit as claimed in claim 2 wherein the signal pads are respectively input/output and complementary input/output.

4. An integrated circuit as claimed in any preceding claim wherein the power supply pads comprise a ground pad and a supply voltage pad.

5. An integrated circuit as claimed in any preceding claim further including a global signal routing channel (26).

## Patentansprüche

1. Integrierte Schaltung mit einer E/A-Struktur, die längs eines Randes der integrierten Schaltung angeordnet ist, wobei die E/A-Struktur enthält:
mehrere in einer Zeile längs des Randes angeordnete Energieversorgungs-Kontaktflächen (16, 18) und Signal-Kontaktflächen (20, 22), und
mehrere in einer benachbarten Zeile, parallel zu den Kontaktflächen angeordnete E/A-Pufferschaltungen (24),
wobei jede der E/A-Pufferschaltungen mit einer jeweiligen Signal-Kontaktfläche oder einem Differenzpaar von Signal-Kontaktflächen verbunden ist,
wobei jede der E/A-Pufferschaltungen in Richtung der Zeilen länger als in der dazu senkrechten Richtung sind, und wobei sich jede der E/A-Pufferschaltung in Richtung der Zeilen so erstreckt, daß sie einen Abschnitt aufweist, der sich in dieser Richtung gleich weit wie ihre gesamte jeweiligeSignal-Kontaktfläche oder ihr Differenzpaar von Signalkontaktflächen erstreckt, und einen Abschnitt aufweist, der sich in dieser Richtung gleich weit wie wenigstens ein Abschnitt einer Energieversorgungs-Kontaktfläche erstreckt.

2. Integrierte Schaltung nach Anspruch 1, bei der jede der E/A-Pufferschaltungen (24) mit einem jeweiligen Differenzpaar von Signal-Kontaktflächen (20, 22) verbunden ist und jede der E/A-Pufferschaltungen sich in Richtung der Zeilen erstreckt, so daß sie einen Abschnitt aufweist, der sich in dieser Richtung gleich weit wie ihr gesamtes jeweiliges Differenzpaar von Signal-Kontaktflächen erstreckt.

3. Integrierte Schaltung nach Anspruch 2, bei der die Signal-Kontaktflächen jeweils Eingang/Ausgang und komplementärer Eingang/Ausgang sind.

4. Integrierte Schaltung nach einem der vorhergehenden Ansprüche, bei der die Energieversorgungs-Kontaktflächen eine Masse-Kontaktfläche und eine Versorgungsspannungs-Kontaktfläche sind.

5. Integrierte Schaltung nach einem der vorhergehenden Ansprüche, ferner mit einem globalen Signalführungskanal (26).

## Revendications

1. Circuit intégré ayant une structure d'E/S agencée le long d'un bord du circuit intégré, la structure d'E/S comprenant :
une pluralité de plots d'alimentation électrique (16, 18) et de plots de contact de signal (20, 22) agencés en rangée le long dudit bord, et
une pluralité de circuits de tampons d'E/S (24) agencés en une rangée adjacente parallèle à celle des plots de contact,
chacun desdits circuits de tampons d'E/S étant connecté à un plot de signal respectif ou à une paire différentielle respective de plots de signal,
dans lequel chacun desdits circuits de tampons d'E/S est plus long dans la direction desdites rangées qu'il ne l'est dans la direction perpendiculaire à celle-ci et dans lequel chacun desdits circuits de tampons d'E/S s'étend dans la direction desdites rangées de telle sorte qu'il présente une partie s'étendant dans cette direction et dans le prolongement de l'ensemble de son plot de signal respectif ou de sa paire différentielle respective de plots de signal et une partie s'étendant dans cette direction et dans le prolongement d'au moins une partie d'un plot d'alimentation électrique.

2. Circuit intégré selon la revendication 1, dans lequel chacun desdits circuits de tampons d'E/S (24) est connecté à une paire différentielle respective de plots de signal (20, 22) et chacun desdits circuits de tampons d'E/S s'étend dans la direction desdites rangées de telle sorte qu'il présente une partie s'étendant dans cette direction et dans le prolongement de l'ensemble de sa paire différentielle respective de plots de signal.

3. Circuit intégré selon la revendication 2, dans lequel les plots de signal sont respectivement des plots d'entrées/sorties et des plots d'entrées/sorties complémentaires.

4. Circuit intégré selon une quelconque revendication précédente, dans lequel les plots d'alimentation électrique comprennent un plot de liaison à la terre et un plot de tension d'alimentation.

5. Circuit intégré selon une quelconque revendication précédente, comprenant en outre une voie commune d'acheminement de signaux (26).
